# EUROPÄISCHE PATENTSCHRIFT

(11) **EP 1 365 043 B1**
(45) Veröffentlichungstag und Bekanntmachung des Hinweises auf die Patenterteilung: **05.04.2006**
(21) Anmeldenummer: 03011736.0
(22) Anmeldetag: 23.05.2003
(51) Int. Cl.: C23C 16/54, C23C 16/458

(54) **Vorrichtung für CVD-Beschichtungen**
CVD apparatus
Dispositif de dépôt chimique en phase vapeur

(30) Priorität: 04.06.2002 DE 10224934; 24.05.2002 DE 10223288; 07.06.2002 DE 10225609; 20.06.2002 DE 10227637
(43) Veröffentlichungstag der Anmeldung: 26.11.2003
(73) Patentinhaber: Schott AG, 55122 Mainz (DE)
(72) Erfinder: Arnold, Gregor, 55294 Bodenheim (DE); Lüttringhaus-Henkel, Andreas, 64289 Darmstadt (DE); Behle, Stephan, Dr., 55278 Hahnheim (DE); Bicker, Matthias, Dr., 551226 Mainz (DE)
(74) Vertreter: Blumbach - Zinngrebe

(56) Entgegenhaltungen:
- WO-A-00/58631
- WO-A-99/17334
- DE-A- 10 010 642
- US-A- 5 324 361
- US-A1- 2002 041 942
- PATENT ABSTRACTS OF JAPAN vol. 008, no. 074 (E-236), 6. April 1984 (1984-04-06) & JP 58 223318 A (TOSHIBA KIKAI KK), 24. Dezember 1983 (1983-12-24)

## Beschreibung

Die Erfindung betrifft eine Vorrichtung für CVD-Beschichtungen von Werkstücken, insbesondere eine Vorrichtung zur simultanen Beschichtung mehrerer Werkstücke.

Um die Barrierewirkungen insbesondere von Kunststoffbehältern wie etwa Kunststoffflaschen zu verbessern, können diese mit Barriereschichten versehen werden. Solche Beschichtungen können unter anderem mittels verschiedener CVD-Verfahren (CVD: "Chemical Vapor Deposition", chemische Dampfphasenabscheidung) auf den Behälterwandungen abgeschieden werden.

Für Kunststoffbehälter ist dabei insbesondere das Plasma Impulse CVD Verfahren (PICVD)(gepulstes Mikrowellenplasma) als Abscheideverfahren geeignet. Gegenüber der plasmaunterstützten chemischen Dampfphasenabscheidung (PECVD), bei welcher das Plasma kontinuierlich aufrechterhalten wird, ist das PICVD-Verfahren unter anderem deshalb vorteilhaft, weil sich mit diesem Verfahren die Aufheizung der temperaturempfindlichen Kunststoffe reduzieren läßt. Außerdem wird während der Zeitphasen außerhalb der Pulse, in denen kein Plasma angeregt ist, ein Gasaustausch ermöglicht.

Bei Beschichtungsanlagen im Labormaßstab werden dazu die Kunststoffbehälter in eine Beschichtungsstation eingesetzt, wobei diese Station komplett mit allen technischen Einrichtungen ausgerüstet ist, welche zur Beschichtung notwendig sind. Dazu gehören unter anderem Vakuumpumpen, Gaszuführung, Sensoren und die Mikrowelleneinkopplung. Nach dem Schließen einer vakuumdichten Glocke kann der Hohlkörper innen und außen evakuiert werden und das Beschichten der Innen- und/oder Außenseite des Behälters durchgeführt werden.

Für Beschichtungen im industriellen Maßstab ist dazu eine Maschine mit entsprechend hoher Leistung erforderlich. Hierzu sind beispielsweise kontinuierlich laufende Rundläufer mit radial angeordneten, identischen Beschichtungsstationen geeignet.

Problematisch ist hierbei, wenn die abzuscheidenden Schichten lange Beschichtungszeiten erfordern. Beispielsweise können bestimmte Beschichtungen reine Beschichtungszeiten von länger als 20 Sekunden benötigen. Auch sind lange Verweilzeiten in den Beschichtungssektionen dann erforderlich, wenn die Beschichtung in mehreren Schritten erfolgen soll. Denkbar ist dazu beispielsweise, wenn vor der Beschichtung eine Aktivierung der Oberfläche von Kunststoffkörpern erfolgen soll oder wenn mehrere Schichten nacheinander aufgebracht werden müssen. In diesen Fällen ist eine kontinuierlich laufende Rundläufervorrichtung nicht mehr wirtschaftlich zu betreiben, da sie entweder entsprechend langsam laufen oder der Umfang an die Prozeßzeiten angepaßt werden muß, was sehr große und entsprechend teure Maschinen erfordert.

Die Erfindung hat sich daher die Aufgabe gestellt, das CVD-Beschichten auch für lange Prozeßzeiten wirtschaftlicher zu machen.

Bei Beschichtungsanlagen im Labormaßstab werden dazu die Kunststoffbehälter in eine Beschichtungsstation eingesetzt, wobei diese Station komplett mit allen technischen Einrichtungen ausgerüstet ist, welche zur Beschichtung notwendig sind. Dazu gehören unter anderem Vakuumpumpen, Gaszuführung, Sensoren und die Mikrowelleneinkopplung. Nach dem Schließen einer vakuumdichten Glocke kann der Hohlkörper innen und außen evakuiert werden und das Beschichten der Innen- und/oder Außenseite des Behälters durchgeführt werden.

Für Beschichtungen im industriellen Maßstab ist dazu eine Maschine mit entsprechend hoher Leistung erforderlich. Hierzu sind beispielsweise kontinuierlich laufende Rundläufer mit radial angeordneten, identischen Beschichtungsstationen geeignet.

Um die Naschinenleiatung zu erhöhen können auch mehrere Werkstücke in einer Beschichtungskammer gleichzeitig beschichtet werden. Derartige Anlagen sind beispielsweise aus der WO 00/58631, DE 100 10 642 und US 2002/0041942 bekannt

Problematisch ist hierbei, wenn die abzuscheidenden Schichten lange Beschichtungszeiten erfordern. Beispielsweise können bestimmte Beschichtungen reine Beschichtungszeiten von länger als 20 Sekunden benötigen. Auch sind lange Verweilzeiten in den Beschichtungssektionen dann erforderlich, wenn die Beschichtung in mehreren Schritten erfolgen soll. Denkbar ist dazu beispielsweise, wenn vor der Beschichtung eine Aktivierung der Oberfläche von Kunststoffkörpern erfolgen soll oder wenn mehrere Schichten nacheinander aufgebracht werden müssen. In diesen Fällen ist eine kontinuierlich laufende Rundläufervorrichtung nicht mehr wirtschaftlich zu betreiben, da sie entweder entsprechend langsam laufen oder der Umfang an die Prozeßzeiten angepaßt werden muß was sehr große und entsprechend teure Maschinen erfordert.

Die Erfindung hat sich daher die Aufgabe gestellt, das CVD-Beschichten auch für lange Prozeßzeiten wirtschaftlicher zu machen.

Diese Aufgabe wird bereits in überraschend einfacher Weise durch eine Vorrichtung für CVD-Beschichtungen von Werkstücken gemäß Anspruch 1, sowie ein Verfahren zum CVD-Beschichten von Werkstücken gemäß Anspruch 22 gelöst. Vorteilhafte Weiterbildungen sind Gegenstand der jeweiligen Unteransprüche.

Demgemäß umfaßt eine erfindungsgemäße Vorrichtung für CVD-Beschichtungen eine Transporteinrichtung, zumindest eine Beschichtungsstation zur Beschichtung von Werkstücken, zumindest eine Einrichtung zum Evakuieren und eine Einrichtung zur Erzeugung eines Plasmas in wenigstens einem Teilbereich der Beschichtungsstation, wobei in der zumindest einen Beschichtungsstation wenigstens zwei Werkstücke aufnehmbar sind.

Dadurch, daß die Beschichtungsstation gleichzeitig mehrere Werkstücke aufnehmen kann, können bei gleichbleibendem Durchsatz die Prozeßzeiten um einen Faktor erhöht werden, welcher der Anzahl der in der Beschichtungsstation aufnehmbaren Werkstücke entspricht. Auf diese Weise wird es erreicht, daß die Vorrichtung in ihren Abmessungen klein gehalten werden kann und dennoch lange Beschichtungszeiten bei gleichzeitig hohem Durchsatz realisiert werden können.

Für viele Ausführungsformen ist es ferner günstig, wenn die zumindest eine Beschichtungsstation mit der Transporteinrichtung befördert wird.

Bevorzugt umfaßt die Einrichtung zur Erzeugung eines Plasmas in wenigstens einem Teilbereich der Beschichtungsstation eine Einrichtung zur Erzeugung eines gepulsten Plasmas. Durch einer solche Einrichtung wird die PICVD-Beschichtung der Werkstücke mit den oben aufgeführten Vorteilen ermöglicht.

Die Aufnahme mehrerer Werkstücke kann in einfacher Weise dadurch bewerkstelligt werden, daß diese auf zumindest einem Halter angeordnet werden, welche in der zumindest einen Beschichtungsstation aufnehmbar ist. Dabei können die Werkstücke sowohl in einer Ebene, als auch in einer räumlichen Anordnung in mehreren Ebenen gestapelt werden.

Vorteilhaft kann die Vorrichtung ferner so ausgestaltet sein, daß die Transporteinrichtung die Beschichtungsstation nacheinander von zumindest einer Zuführposition zu zumindest einer Pumpposition, zumindest einer Beschichtungsposition und zumindest einer Entladeposition befördert. Insbesondere kann dabei die Vorrichtung zumindest vier Beschichtungsstationen aufweisen, welche so auf der Transporteinrichtung angeordnet sind, daß sich jeweils eine der Beschichtungsstationen in der Zuführposition, der Evakuierungsposition und der Entladeposition befindet, wenn sich eine der Beschichtungsstationen in der Beschichtungsposition befindet. Auf diese Weise wird es ermöglicht, daß jede der Beschichtungsstationen an einem Schritt des Prozeßablaufes beteiligt ist und so der Prozeßablauf zeitlich optimiert wird.

Der Prozeßablauf kann auch dadurch optimiert werden, daß die Transporteinrichtung während des Beschichtens die Transportgeschwindigkeit verlangsamt. Insbesondere ist es dabei vorteilhaft, wenn die Transporteinrichtung während des Beschichtens anhält. Durch die damit bewirkte Abkehr von einem kontinuierlichen Produktionsprozeß wird so eine bessere zeitliche Ausnutzung der im allgemeinen unterschiedlich langen Phasen des Produktionsprozesses erreicht.

Gemäß einer bevorzugten Ausführungsform der Erfindung umfaßt die Transporteinrichtung eine Rundläufervorrichtung. Diese lassen sich besonders kompakt und mit vergleichsweise einfacher Mechanik herstellen. Es ist jedoch auch möglich, ein Langläufersystem zu verwenden, welches beispielsweise den Vorteil eines freien Zugangs zu den Beschichtungsstationen von zwei gegenüberliegenden Seiten her bietet.

In einfacher Weise läßt sich ein Plasma in wenigstens einem Teilbereich der Beschichtungsstation mittels einer Einrichtung zur Erzeugung elektromagnetischer Wellen erzeugen. Insbesondere ist dabei die Erzeugung von Mikrowellen von Vorteil, welche sich leicht durch Hohlleiter transportieren lassen und hohe Energiedichten übertragen können.

Günstig ist es ferner, wenn die erfindungsgemäße Vorrichtung eine Einrichtung zur Verbindung der Einrichtung zur Erzeugung elektromagnetischer Wellen mit der zumindest einen Beschichtungsstation aufweist. Dadurch wird es möglich gemacht, daß die Einrichtung zur Erzeugung elektromagnetischer Wellen nicht mit den Beschichtungsstationen mitgeführt werden muß. Vielmehr kann eine solche Einrichtung die Verbindung der Einrichtung zur Erzeugung elektromagnetischer Wellen mit der zumindest einen Beschichtungsstation erst beim Erreichen eines bestimmten Beschichtungsbereiches herstellen.

Insbesondere ist es für einen einfachen Aufbau der Vorrichtung von Vorteil, wenn die Einrichtung zur Erzeugung elektromagnetischer Wellen stationär angeordnet ist. Damit wird ein Mitführen der Einrichtung mit der zumindest einen Beschichtungsstation vermieden. Insbesondere wird damit erreicht, daß nicht jede Beschichtungsstation eine eigene Plasmaerzeugungseinrichtung benötigt, welche auf der Transporteinrichtung mitgeführt werden muß und so den apparativen Aufwand für eine Vorrichtung zum CVD-Beschichten enorm erhöht.

Damit der für die Plasmabeschichtung notwendige Enddruck schneller erreicht werden kann, sind zumindest zwei, besser mehrere Pumpvorrichtungen, beziehungsweise Pumpstufen von Vorteil. Die Pumpstufen können dazu für verschiedene Druckbereiche optimiert werden. Ein sequentielles Zu- und Abschalten der Pumpstufen ermöglicht dann ein schnelles Erreichen des Enddrucks mit im Vergleich zu einer einzelnen Pumpstufe deutlich reduzierten Pumpleistung.

Außerdem kann die erfindungsgemäße Vorrichtung noch eine Einrichtung zum sequentiellen Verbinden der zumindest einen Beschichtungsstation mit den zumindest zwei Pumpstufen aufweisen. Diese kann beispielsweise die Verbindung mit der Beschichtungsstation bei bestimmten Positionen der Transporteinrichtung herstellen, etwa an vorgesehenen Drehpositionen bei einer Rundläufer-Transporteinrichtung.

Um die Werkstücke während der Evakuierung und Beschichtung sicher zu fixieren, kann die erfindungsgemäße Vorrichtung außerdem vorteilhaft Befestigungseinrichtungen für die zumindest zwei Werkstücke aufweisen. Insbesondere können die Befestigungseinrichtungen auch Aufnahmen für hohlkörperförmige Werkstücke, insbesondere für Flaschen umfassen.

Vorteilhaft ist für alle Ausführungsformen der Erfindung außerdem eine Einrichtung zum Einlassen von Prozeßgasen. Diese kann für die Beschichtung von Hohlkörpern wie Kunststoffflaschen oder Glasflaschen auch so ausgebildet sein, daß die Prozeßgase in den Hohlkörper eingelassen werden. Ist der Hohlkörper in einer abdichtenden Aufnahme fixiert, so können auf diese Weise im Innen- und Außenbereich des Hohlkörpers unterschiedliche Gaszusammensetzungen erzeugt werden. Damit lassen sich auf den Innen- und Außenwandungen der Hohlkörper unterschiedliche Schichten herstellen oder etwa reine Innen- oder Außenbeschichtungen erzielen, wenn die Gaszzusammensetzungen derart gewählt werden, daß nur im Innen- oder Außenbereich durch Einwirkung elektromagnetischer Strahlung ein Plasma erzeugt wird.

Im Rahmen der Erfindung liegt es auch, ein Verfahren zum CVD-Beschichten von Werkstücken anzugeben, mit welchen auch bei langen Prozesszeiten eine wirtschaftliche Beschichtung realisiert werden kann. Das Verfahren zum CVD-Beschichten von Werkstücken, welches insbesondere mit einer erfindungsgemäßen Vorrichtung ausgeführt werden kann umfasst die Schritte:
- Einführen von zumindest zwei Werkstücken in eine Beschichtungsstation,
- Evakuieren,
- Befördern der zumindest zwei Werkstücke mit einer Transporteinrichtung,
- Erzeugen eines Plasmas in zumindest einem Teilbereich der Beschichtungsstation,
- Belüften, und
- Ausführen der Werkstücke.

Durch das Erzeugen eines Plasmas in zumindest einem Teilbereich kommt es zu chemischen Reaktionen der Bestandteile des Prozeßgases, welches das Plasma bildet. Die Edukte der Reaktionen im Plasma werden dann auf den an das Plasma angrenzenden Flächen der Werkstücke als Beschichtung abgeschieden.

Durch das Behandeln mehrerer Werkstücke in einer gemeinsamen Beschichtungsstation, in welcher das Plasma erzeugt wird, läßt sich entsprechend der Anzahl gemeinsam behandelter, beziehungsweise beschichteter Werkstücke die Prozeßzeit verlängern, ohne den Durchsatz zu verringern. Um den Vorteil einer Beschichtung in einer gemeinsamen BEschichungsstation auszunutzen, umfaßt außerdem der Schritt des Erzeugens eines Plasmas in zumindest einem Teilbereich vorteilhaft den Schritt des gemeinsamen CVD-Beschichtens zumindest zweier Werkstücke.

Vorteilhaft für verschiedene Varianten des erfindungsgemäßen Verfahrens ist ferner, wenn die zumindest eine Beschichtungsstation mit der Transporteinrichtung befördert wird. Auf diese Weise werden beispielsweise die Werkstücke zusammen mit der Beschichtungsstation, in welcher die WErkstücke aufgenommen sind, weitertransportiert und verschiedene Behandlungsschritte können so während der Bewegung der Transporteinrichtung vorgenommen werden.

Besonders vorteilhaft ist eine Ausgestaltung des Verfahrens, bei welchem der Schritt des Erzeugens eines Plasmas in zumindest einem Teilbereich der Beschichtungsstation den Schritt des Erzeugens eines gepulsten Plasmas umfaßt. Durch ein gepulstes Plasma können unter anderem im Puls hohe Leistungen im Plasma umgesetzt und die zeitlich gemittelte Leistung gleichzeitig niedrig gehalten werden.

Das Anordnen der Werkstücke auf Haltern, welche in die Beschichtungsstation eingeführt werden, ist besonders vorteilhaft für das erfindungsgemäße Verfahren, da dieser Schritt außerhalb der Beschichtungsvorrichtung durchgeführt werden kann, wodurch Raum für entsprechende Vorrichtungen, wie beispielsweise Robotergreifarme zur Verfügung gestellt werden kann.

Eine besonders günstige Raumausnutzung kann erzielt werden, wenn die Werkstücke in der Beschichtungsstation auf zumindest zwei Ebenen angeordnet sind. Dies kann beispielsweise durch eine entsprechende Anordnung auf einem Halter bewerkstelligt werden.

Außerdem kann mit Vorteil der Schritt des Beförderns der Beschichtungsstation mit einer Transporteinrichtung die Schritte des Beförderns von einer Zuführposition zu einer Evakuierungsposition, einer Beschichtungsposition und einer Entladeposition umfassen.

Um den Ablauf des Verfahrens zeitlich weiter zu optimieren, kann weiterhin der Schritt des Beförderns der Beschichtungsstation mit einer Transporteinrichtung den Schritt des Verlangsamens der Transportgeschwindigkeit während des Beschichtens, insbesondere den Schritt des Anhaltens während des Beschichtens umfassen.

Vorzugsweise umfasst ferner der Schritt des Erzeugens eines Plasmas in zumindest einem Teilbereich der Beschichtungsstation den Schritt des Erzeugens elektromagnetischer Wellen, insbesondere des Erzeugens von Mikrowellen. Vorteilhaft kann ferner der Schritt des Erzeugens eines Plasmas den Schritt des Einlassens eines Prozessgases umfassen.

Gemäß einer vorteilhaften Weiterbildung der Erfindung umfasst das Verfahren außerdem den Schritt des Verbindens einer Einrichtung zur Erzeugung elektromagnetischer Wellen mit der zumindest einen Beschichtungsstation. Auf diese Weise können die elektromagnetischen Wellen mit einer stationären Einrichtung erzeugt werden, während sich die Transporteinrichtung mit der Beschichtungsstation daran vorbeibewegen kann und dabei mit der Einrichtung zur Erzeugung elektromagnetischer Wellen verbunden wird.

Um schnell den erforderlichen Enddruck beim Evakuieren zu erreichen, kann der Schritt des Evakuierens zusätzlich den Schritt des sequentiellen Evakuierens mit zumindest zwei Pumpstufen umfassen.

Um eine Innenbeschichtung hohlkörperförmiger Werkstücke, wie insbesondere von Flaschen zu bewerkstelligen, ist es günstig, auch den Hohlraum zu evakuieren, welcher von den hohlkörperförmigen Werkstücken umschlossen wird. Bei der Beschichtung von Flaschen wird also gemäß dieser vorteilhaften Weiterbildung beispielsweise das Flascheninnere evakuiert. Für die Beschichtung solcher Werkstücke ist es weiterhin günstig, wenn der Schritt des Einlassens eines Prozessgases den Schritt des Einlassens eines Prozessgases in den Hohlraum hohlkörperförmiger Werkstücke umfaßt.

Die Erfindung wird nachfolgend beispielhaft anhand von bevorzugten Ausführungsformen unter Bezugnahme auf die beigefügten Zeichnungen näher beschrieben. Gleiche Bezugszeichen in den Zeichnungen kennzeichnen dabei gleiche oder ähnliche Teile.

Dabei zeigen:
- Fig. 1: eine schematische Aufsicht auf eine erste Ausführungsform der Erfindung mit Rundläufer-Transporteinrichtung,
- Fig. 2: eine schematische Aufsicht auf eine zweite Ausführungsform der Erfindung mit Rundläufer-Transporteinrichtung,
- Fig. 3: eine schematische Aufsicht auf eine dritte Ausführungsform der Erfindung mit Rundläufer-Transporteinrichtung, und
- Fig. 4: eine schematische Ansicht einer als Langläufer ausgeführten erfindungsgemäßen Vorrichtung.

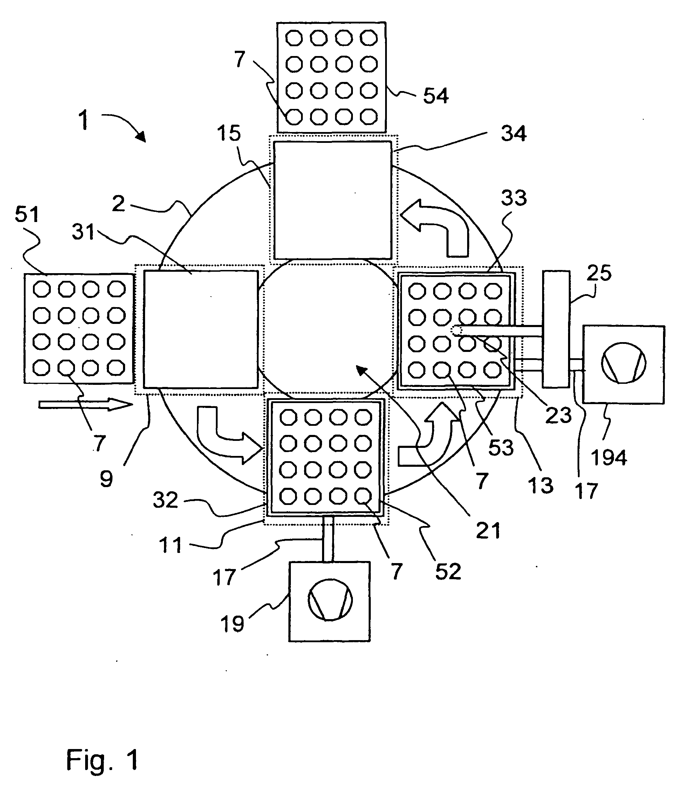

In Fig. 1 ist eine schematische Aufsicht auf eine erste Ausführungsform der im ganzen mit 1 bezeichneten erfindungsgemäßen Vorrichtung für CVD-Beschichtungen dargestellt. Die Vorrichtung 1 umfaßt in dieser Ausführungsform eine Transporteinrichtung 2 in der Form eines Rundläufers. Auf dem Rundläufer 2 sind vier Beschichtungsstationen 31, 32, 33, 34 befestigt.

Die zu beschichtenden Werkstücke werden auf Haltern in Form von Paletten 51, 52, 53, 54 angeordnet, welche den Beschichtungsstationen 31 - 34 zugeführt werden.

Die Werkstücke werden auf den Paletten dabei in geeigneten Befestigungseinrichtungen oder Aufnahmen 7 befestigt. Das Anordnen der Werkstücke auf den Paletten, sowie das Herunternehmen von den Paletten kann dabei beispielsweise von Robotergreifarmen durchgeführt werden. Bei der in Fig. 1 gezeigten Ausführungsform der Vorrichtung 1 befinden sich jeweils 16 Aufnahmen 7 auf einer Palette. Entsprechend können in einer Beschichtungsstation jeweils 16 Werkstücke gleichzeitig beschichtet werden.

Das Zuführen der auf einer der Paletten 51 - 54 befestigten Werkstücke zu einer Beschichtungsstation 31 - 34 geschieht, wenn sich die Beschichtungsstation auf der Transporteinrichtung 2 in einer Zuführposition 9 befindet. Die Zuführposition entspricht einem bestimmten Drehwinkel oder Drehwinkelbereich des Rundläufers.

Befindet sich eine der Beschichtungsstationen, in Fig. 1 die Beschichtungsstation 31 in der Zuführposition, so befindet sich jeweils eine der weiteren Beschichtungsstationen 32, 33, 34 in einer Evakuierungsposition 11, einer Beschichtungsposition 13 und einer Entladeposition 15.

Ist die Palette der Beschichtungsstation 31 zugeführt, so kann diese geschlossen werden und die Beschichtungsstationen werden auf der Transporteinrichtung 2 weiterbefördert, bis sich die Beschichtungsstation 31 an der Pumpposition 11 befindet. In dem in Fig. 1 gezeigten Zustand der Vorrichtung befindet sich die Beschichtungsstation 32 mit der darin aufgenommenen Palette 52 in der Pumpposition. In dieser Position wird mittels einer geeigneten Einrichtung eine Verbindung der Beschichtungsstation 32 mit einer Einrichtung 19 zum Evakuieren hergestellt. Die Verbindungseinrichtung umfasst in dieser Ausführungsform Vakuumleitungen 17. Die Einrichtung zum Evakuieren kann beispielsweise Kombinationen von verschiedenartigen Pumpen umfassen, welche von der Verbindungseinrichtung sequentiell zugeschaltet werden, um für den momentan in der Beschichtungsstation 32 herrschenden Druck eine optimale Pumpleistung bereitstellen zu können. Die Einrichtung 19 zum Evakuieren kann auch anders als in Fig. 1 gezeigt, im Innenbereich 21 des Rundläufers angeordnet sein, um einen möglichst platzsparenden Aufbau der Vorrichtung 1 zu realisieren.

Nach der Evakuierung der Beschichtungsstation wird die Transporteinrichtung weiterbewegt, bis sich die Beschichtungsstation in der Beschichtungsposition 13 befindet. In der Beschichtungsposition 13 wird eine Einrichtung 25 zur Erzeugung von Mikrowellen mit der Beschichtungsstation verbunden. Beispielsweise kann dies mittels geeigneter Hohlleiter 23 geschehen, wobei in Fig. 1 nur ein einzelner Hohlleiter gezeigt ist. Günstig ist es auch für alle hier beschriebenen Ausführunsformen, wenn die Beschichtungsstationen mit mehreren Hohlleitern 23, etwa ein Hohlleiter pro Werkstück angeschlossen werden, um eine gleichmäßige Verteilung der Strahlung in der Beschichtungsstation herzustellen.

In der Beschichtungsposition 13 wird außerdem das für die Beschichtung geeignete Prozessgas in die Beschichtungsstation eingelassen und mit geeigneten Pumpen auf den notwendigen Prozessdruck eingestellt. und mit einer Pumpvorrichtung 194 auf den notwendigen Prozessdruck eingestellt. Die mittels einer Zuleitung 17 mit der sich jeweils in der Beschichtungsposition 13 befindenden Beschichtungsstation verbundene Pumpvorrichtung 194 kann außerdem die Prozeßgase abpumpen, welche über eine nicht gezeigte Einrichtung während des Beschichtens zugeführt werden, so daß während des Beschichtens ein Gasaustausch ermöglicht wird. Mittels der von der Einrichtung 25 in die Beschichtungsstation eingestrahlten Mikrowellen wird dann im Inneren der Beschichtungsstation ein Plasma erzeugt, wodurch sich durch die im Plasma in Gang gesetzten chemischen Reaktionen eine CVD-Schicht auf den im Bereich des Plasmas befindlichen Flächen der Werkstücke bildet.

Insbesondere kann auch das Gas bei hohlkörperförmigen Werkstücken wie Kunststoffflaschen in das Innere des Hohlkörpers eingelassen werden. Dazu sind Aufnahmen 7 der Paletten so eingerichtet, dass sie mit dem darauf befestigten Werkstück einen abgeschlossenen Hohlraum schaffen, welcher teilweise von den Innenwandungen der hohlkörperförmigen Werkstücken begrenzt wird. In diesen Hohlraum wird dann das Prozessgas eingelassen. Werden die Mikrowellen eingestrahlt, so kommt es dann im Inneren der Werkstücke, beziehungsweise in den jeweils mit Aufnahme 7 und Werkstück gebildeten Hohlräumen zur Plasmabildung und Schichtabscheidung. Auf diese Weise kann eine Innenbeschichtung von hohlkörperförmigen Werkstücken vorgenommen werden. Wird das Prozessgas nur in die Hohlräume eingeleitet, so bildet sich außerhalb der Hohlräume kein Plasma aus, wenn der Druck durch das Evakuieren zu niedrig ist. Alternativ können mit der Einrichtung 19 auch nur die gebildeten Hohlräume evakuiert werden, so dass sich die übrigen Teile der Beschichtungsstation unter Normaldruck befinden. Aufgrund der hohen Gasdichte und der damit verbundenen kleinen freien Weglänge der Gasmoleküle kommt es auch in diesem Fall nicht zur Plasmabildung in diesen Teilen der Beschichtungsstation.

Weiterhin können bei hohlkörperförmigen Werkstücken auch verschiedene Prozessgase in die Hohlräume und die übrigen Bereiche in der Beschichtungsstation eingeleitet werden. Auf diese Weise können die Innen- und Außenwandungen der Werkstücke mit verschiedenenartigen Schichten versehen werden. Beispielsweise können Kunststoffflaschen zweckmäßig eine Innenbeschichtung mit einer Diffusionsbarriere und eine Außenbeschichtung mit einer UV-Schutzschicht erhalten.

Nach abgeschlossenem Beschichtungsvorgang wird die Beschichtungsstation dann mit der Transporteinrichtung weiter zu einer Entladeposition 15 transportiert, wo mittels einer geeigneten Vorrichtung die Palette mit den beschichteten Werkstücken entnommen wird.

Während des gesamten Prozessablaufs kann sich die Transporteinrichtung kontinuierlich bewegen. Vorteilhaft ist aber, wenn die Transporteinrichtung während des Beschichtungsvorgangs anhält, so dass bei einer stationären Einrichtung 25 zur Erzeugung von Mikrowellen die Holleiter 23 nicht bewegt werden brauchen. Auch das Verbinden mit der Einrichtung 19 zum Evakuieren und das Abpumpen lassen sich bei ruhender Transporteinrichtung einfach bewerkstelligen.

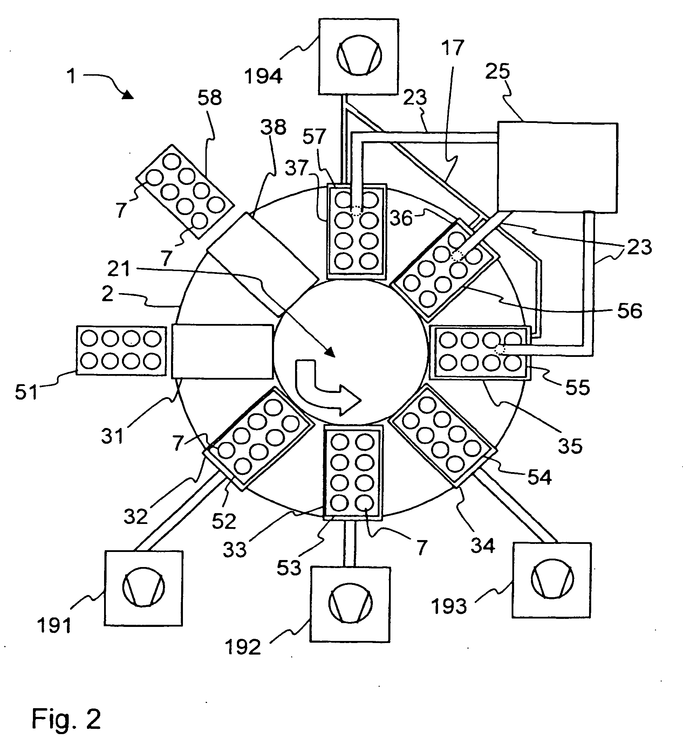

Im folgenden wird auf Fig. 2 Bezug genommen, in welcher schematisch eine weitere Ausführungsform der erfindungsgemäßen Vorrichtung 1 dargestellt ist.

Diese Ausführungsform der Vorrichtung 1 für CVD-Beschichtungen umfasst acht Beschichtungsstationen 31 - 38. Die Halter in Form von Paletten 51 - 58 sind für die Aufnahme von jeweils acht Werkstücken geeignet. Im Gegensatz zu der anhand von Fig. 1 veranschaulichten Ausführungsform werden die Beschichtungsstationen 31 - 38 mit der Transporteinrichtung nacheinander mehreren Evakuierungspositionen und Beschichtungspositionen zugeführt. Der Blockpfeil gibt dabei den Drehsinn des Rundläufers an.

In dem in Fig. 2 gezeigten Zustand befindet sich die Beschichtungsstation 32 in einer ersten Evakuierungsposition, die Beschichtungsstation 33 in einer zweiten und die Beschichtungsstation 34 in einer dritten Evakuierungsposition.

Die Einrichtung zum Evakuieren der Beschichtungsstationen umfasst dabei in dieser Ausführungsform der Erfindung für jede der Evakuierungspositionen Pumpvorrichtungen 191, 192 und 193, mit denen jeweils eine Beschichtungsstation verbunden wird, die sich in einer dieser Positionen befindet.

Die Beschichtungsstationen werden so schrittweise auf bestimmte Vakuumdrücke evakuiert. Die Pumpvorrichtungen können dabei vorzugsweise für unterschiedliche Druckbereiche optimiert sein, um auch mit geringerer Pumpleistung ein effektives Evakuieren der Beschichtungsstationen zu erreichen.

Weiterhin unterscheidet sich die in Fig. 2 gezeigte Ausführungsform von der in Fig. 1 dargestellten Variante dahingehend, dass auch die CVD-Beschichtung an mehreren Positionen durchgeführt wird. Bei dem in Fig. 2 gezeigten Zustand der Vorrichtung befindet sich die Beschichtungsstation 35 in einer ersten, die Beschichtungsstation 36 in einer zweiten und die Beschichtungsstation 37 in einer dritten Beschichtungsposition. In jeder dieser Positionen werden die Beschichtungsstationen über Hohlleiter 23 mit einer Einrichtung 25 zur Erzeugung von Mikrowellen verbunden. Die über die Hohlleiter 23 in die Beschichtungsstationen geleiteten Mikrowellen erzeugen dann in den Bereichen, in denen sich das Prozessgas befindet, ein Plasma, woraufhin die im Plasma entstehenden Reaktionsprodukte auf den mit dem Plasma in Kontakt stehenden Flächen der Werkstücke abgeschieden werden. Wie die in Fig. 1 gezeigte Vorrichtung kann auch diese Variante dafür ausgelegt sein, eine Innenbeschichtung hohlkörperförmiger Werkstücke, wie beispielsweise Kunststoffflaschen zu bewirken. Es können auch verschiedene Prozessgase in den einzelnen Positionen zugeführt werden, so dass dort jeweils verschiedene Beschichtungen aufgebracht werden. Um einen Gasaustausch während der Beschichtung zu ermöglichen, sind die Beschichtungsstationen, die sich jeweils an den Beschichtungspositionen befinden, über Zuleitungen 17 an eine weitere Pumpvorrichtung 194 angeschlossen.

Das Zuführen und Herausnehmen der Paletten kann wie bei der in Fig. 1 gezeigten Ausführungsform durchgeführt werden. Bei der in Fig. 2 gezeigten Stellung der Vorrichtung 1 befindet sich die Beschichtungsstation 31 in der Zuführposition und die Beschichtungsstation 38 in der Entladeposition.

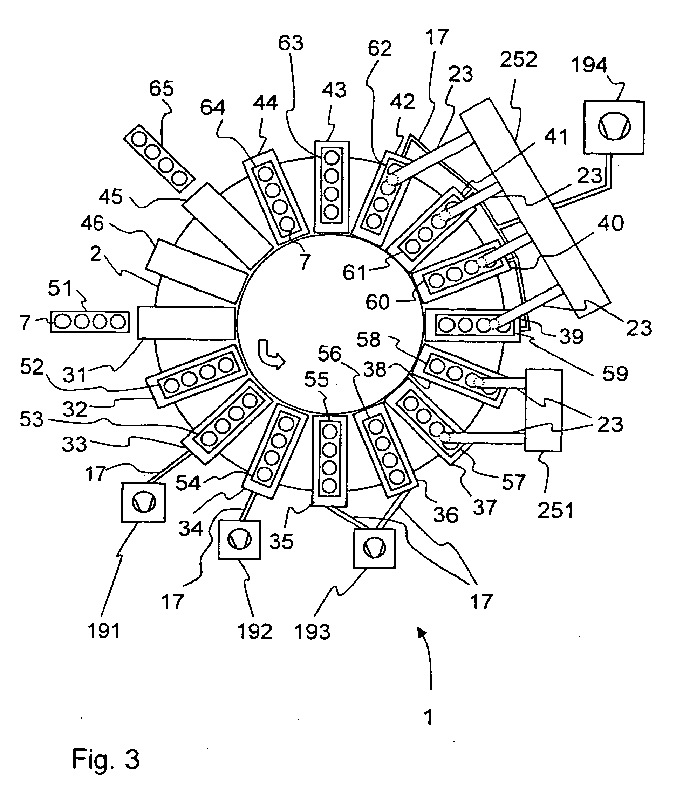

Im folgenden wird auf Fig. 3 Bezug genommen, in welcher eine weitere Ausführungsform der Erfindung dargestellt ist. Diese Ausführungsform umfasst 16 Beschichtungsstationen 31 - 45, welche ähnlich zu den anhand der Figuren 1 und 2 dargestellten Ausführungsformen Halter in Form von Paletten 51 - 64 aufnehmen. Die Paletten 51 - 64 weisen Aufnahmen 7 für jeweils vier Werkstücke auf. Wie in der in Fig. 2 gezeigten Ausführungsform werden die Beschichtungsstationen mit drei Vakuumpumpstufen 191, 192, 193 evakuiert. Dabei sind zwei Evakuierungspositionen, bei denen sich in der dargestellten Stellung der Vorrichtung 1 die Beschichtungsstationen 35 und 36 befinden, der letzten Pumpstufe 193 zugeordnet. Damit sind die Beschichtungsstationen mit der letzten Pumpstufe jeweils doppelt so lange verbunden, wie mit den beiden anderen Pumpstufen. Dies ist vorteilhaft, da das Saugvermögen von Vakuumpumpen bei sinkendem Druck nachlässt.

Die Beschichtung wird in zwei Stufen durchgeführt, wobei der ersten Stufe zwei Beschichtungspositionen und der zweiten Stufe vier Beschichtungspositionen zugeordnet sind. Dazu werden die Beschichtungsstationen wieder mit Hohlleitern 23 verbunden, die an Einrichtungen zur Erzeugung von Mikrowellen 251, beziehungsweise 252 angeschlossen sind. Die Hohlleiter können bei Wechsel der Beschichtungsposition neu verbunden oder auch mitgeführt werden, um eine Unterbrechung bei der CVD-Beschichtung zu vermeiden.

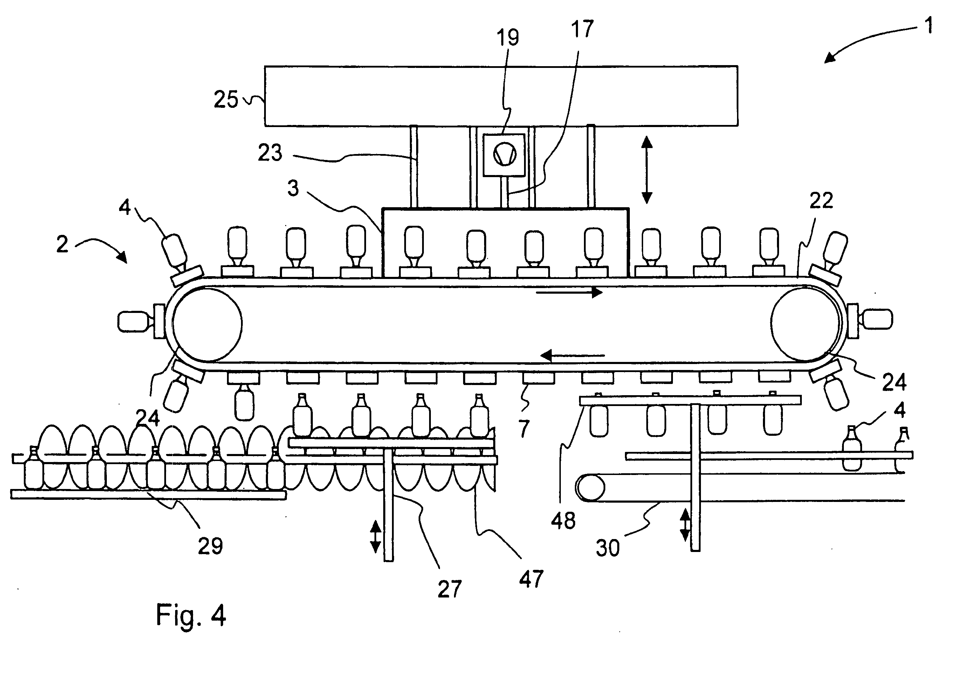

Fig. 4 zeigt eine schematische Ansicht einer als Langläufer ausgeführten erfindungsgemäßen Vorrichtung. Die Transporteinrichtung 2 dieser Ausführungsform umfaßt eine durch Rollen 23 geführte Förderkette 22. Die Transportrichtung der um die Rollen 24 geführten Förderkette 22 ist durch Pfeile gekennzeichnet. Auf der Förderkette sind Aufnahmen 7 für die Aufnahme und Befestigung von Flaschen 4 befestigt. Die Flaschen 4 werden auf der Seite eingesetzt und abgenommen, welche der Seite der Förderkette 22 gegenüberliegt. Dies schafft einen sehr kompakten Aufbau der Vorrichtung 1.

Die Flaschen 4 werden zunächst aufrecht auf einer Förderschiene 29 mit einer Förderschnecke 47 zur Vorrichtung 1 befördert und anschließend mit einem Schieber 27 von unten her in die Aufnahmen 7 geschoben. Der Schieber 27 ist vorzugsweise so ausgelegt, daß mehrere Flaschen 4 gleichzeitig in die Aufnahmen 7 geschoben werden können. Mit der Förderschnecke 47 werden die Flaschen 4 auf dem Schieber 27 in definierten Abständen abgestellt, welche den Abständen der Aufnahmen 7 auf der Förderkette entsprechen. Anstelle eines Schiebers kann jedoch auch ein oder mehrere Robotergreifarme oder eine ähnliche Einrichtung verwendet werden. Die Aufnahmen 7 können außerdem auch Klemmen als Befestigungseinrichtung für die Flaschen aufweisen.

Die in den Aufnahmen 7 befestigten Flaschen werden dann durch die Förderkette 22 auf die gegenüberliegende Seite transportiert. In einem weiteren Schritt wird eine Beschichtungsstation 3 abgesenkt, so daß die Flaschen auf der Oberseite der Transporteinrichtung in der Beschichtungsstation aufgenommen werden. Anders als in den oben beschriebenen Ausführungsformen wird bei dieser Ausführungsform die Beschichtungsstation nicht mit der Transporteinrichtung 2 befördert. Die Beschichtungsstation 3 ist dabei bevorzugt so ausgelegt, daß die Anzahl der darin aufnehmbaren Flaschen 4 der Anzahl der gleichzeitig vom Schieber 27 in die Aufnahmen 7 geschobenen Flaschen entspricht, um die Vorteile des erfindungsgemäßen gleichzeitigen Beschichtens mehrerer Werkstücke in einer gemeinsamen Beschichtungsstation nutzen zu können. Die in Fig. 4 dargestellte Version dieser Ausführungsform mit einer Beschichtungsstation für jeweils vier Flaschen ist dabei nur beispiielhaft.

Anschließend wird der Innenraum der Beschichtungsstation durch eine symbolisch dargestellte Einrichtung 19 zum Evakuieren abgepumpt, welche mit der Beschichtungsstation 3 über eine oder mehrere Vakuumleitungen 17 angeschlossen ist.

Daraufhin kann das Prozeßgas in das Flascheninnere der Flaschen 4 eingefüllt werden und dort ein Plasma mittels einer über Hohlleiter 23 mit der Beschichtungsstation 3 verbundenen Einrichtung 25 zur Erzeugung von Mikrowellen gezündet werden. Sowohl die Einrichtung 25 zur Erzeugung von Mikrowellen, als auch die Einrichtung 19 zum Evakuieren können beispielsweise mit der Beschichtungsstation 3 fest verbunden sein und zusammen mit dieser abgesenkt und angehoben werden. Ebenso können diese Einrichtungen auch über flexible oder trennbare Verbindungen mit der Beschichtungsstation 3 verbunden sein, so daß die Einrichtungen 25 und 19 stationär angeordnet sein können.

Nach erfolgter Beschichtung wird das Innere der Beschichtungsstation belüftet, die Beschichtungsstation 3 wieder angehoben und die Flaschen mit der Förderkette weitertransportiert, bis sie wieder auf die Unterseite der Transporteinrichtung 2 gelangen. Von dort aus können die Flaschen 4 dann mittels einer Abnahmeeinrichtung 48 aus den Aufnahmen 7 geholt und auf einem Transportband 30 zum Weitertransport abgesetzt werden. Durch eine derartige Anordnung wird unter anderem erreicht, daß die Flaschen aufrecht zur Vorrichtung 1 hintransportiert und ebenso aufrecht weiter transportiert werden können, so daß für den Transport ohne größere Anpassungen die in Abfüllanlagen benutzte Fördertechnik benutzt werden kann.

### Bezugszeichenliste

- 1: Vorrichtung für CVD-Beschichtungen
- 2: Transporteinrichtung
- 21: Innenbereich der Transporteinrichtung
- 22: Förderkette
- 23: Rollen
- 3, 31 - 46: Beschichtungsstationen
- 51 - 65: Paletten
- 4: Flasche
- 7: Aufnahmen für Werkstücke
- 9: Zuführposition
- 11: Pumpposition
- 13: Beschichtungsposition
- 15: Entladeposition
- 17: Vakuumleitung
- 19: Einrichtung zum Evakuieren
- 191 - 194: Pumpvorrichtungen
- 23: Hohlleiter
- 24: Rolle
- 25, 251, 252: Einrichtung zur Erzeugung von Mikrowellen
- 27: Schieber
- 29: Förderschienen
- 30: Transportband
- 47: Förderschnecke
- 48: Abnahmeeinrichtung

## Patentansprüche

1. Vorrichtung (1) für CVD-Beschichtungen, umfassend eine Transporteinrichtung (2), zumindest eine Beschichtungsstation (3, 31 - 46) zur Beschichtung von Werkstücken, zumindest eine Einrichtung (19) zum. Evakuieren der Beschichtungsstation (3, 31 - 46) und eine Einrichtung zur Erzeugung eines Plasmas in wenigstens einem Teilbereich der Beschichtungsstation (3, 31 - 46),
wobei die zumindest eine Beschichtungsstation (31- 46) mit der Transporteinrichtung (2) befördert wird, in der zumindest einen Beschichtungsstation (3, 31 - 46) zumindest zwei Werkstücke aufnehmbar sind, und
wobei die Einrichtung zur Erzeugung eines Plasmas in wenigstens einem Teilbereich der Beschichtungsstation (3, 31 - 46) eine stationär angeordnete Einrichtung zur Erzeugung elektromagnetischer wellen (25) umfaßt, **gekennzeichnet durch** eine Einrichtung (23) zur Verbindung der Einrichtung (25) zur Erzeugung elektromagnetischer Wellen mit der zumindest einen Beschichtungsstation (3, 31 - 46).

2. Vorrichtung nach Anspruch 1, **dadurch gekennzeichnet, daß** die Transporteinrichtung (2) die Beschichtungsstation (31 - 46) nacheinander von zumindest einer Zuführposition (9) zu zumindest einer Evakuierungsposition (11), zumindest einer Beschichtungsposition (13) und zumindest einer Entladeposition (15) befördert.

3. Vorrichtung nach Anspruch 2, **gekennzeichnet durch** zumindest vier Beschichtungsstationen (31 - 34), welche so auf der Transporteinrichtung (2) angeordnet sind, daß sich jeweils eine der Beschichtungsstationen (31-34) in der zumindest einen Zuführposition (9), der zumindest einen Evakuierungsposition (11) und der zumindest einen Entladeposition (15) befindet, wenn sich eine der Beschichtungsstationen (31 - 34) in der zumindest einen Beschichtungsposition (13) befindet.

4. Vorrichtung nach einem der Ansprüche 1 bis 4, **dadurch gekenzeichnet,** daß die Einrichtung zur Erzeugung eines Plasmas in wenigstens einem Teilbereich der Beschichtungsstation (31 - 46) eine Einrichtung zur Erzeugung eines gepulsten Plasmas umfaßt.

5. Vorrichtung nach einem der Ansprüche 1 bis 4, **dadurch gekennzeichnet, daß** die Werkstücke auf zumindest einem Halter (51 - 65) angeordnet werden, welcher in der zumindest einen Beschichtungsstation (3, 31 - 46) aufnehmbar ist.

6. Vorrichtung nach einem der Ansprüche 1 bis 5, **dadurch gekennzeichnet, daß** die Werkstücke in der Beschichtungsstation auf zumindest zwei Ebenen angeordnet sind.

7. Vorrichtung nach einem der Ansprüche 1 bis 6, **dadurch gekennzeichnet, daß** die Transporteinrichtung (2) während des Beschichtens die Transportgeschwindigkeit verlangsamt, insbesondere anhält.

8. Vorrichtung nach einem der Ansprüche 1 bis 7, **dadurch gekennzeichnet, daß** die Transporteinrichtung (2) eine Rundläufervorrichtung umfaßt.

9. Vorrichtung nach einem der Ansprüche 1 bis 8, **dadurch gekennzeichnet, daß** die Transporteinrichtung (2) eine Langläufervorrichtung umfaßt.

10. Vorrichtung nach einem der vorstehenden Ansprüche, wobei die Einrichtung zur Erzeugung elektromagnetischer Wellen eine Einrichtung (25) zur Erzeugung von Mikrowellen umfaßt.

11. Vorrichtung nach einem der Ansprüche 1 bis 10, **dadurch gekennzeichnet, daß** die Einrichtung (19) zum Evakuieren zumindest zwei Pumpstufen (191, 192, 193) umfaßt.

12. Vorrichtung nach einem der vorstehenden Ansprüche, **gekennzeichnet durch** eine Einrichtung zum sequentiellen Verbinden der zumindest einen Beschichtungsstation (3, 31 - 46) mit den zumindest zwei Pumpstufen (191, 192, 193).

13. Vorrichtung nach einem der Ansprüche 1 bis 12, **gekennzeichnet durch** eine Einrichtung zum Einlassen von Prozeßgasen.

14. Vorrichtung nach einem der Ansprüche 1 bis 13, **gekennzeichnet durch** Befestigungseinrichtungen für die zumindest zwei Werkstücke.

15. Vorrichtung nach Anspruch 14, wobei die Befestigungseinrichtungen Aufnahmen (7) für hohlkörperförmige Werkstücke; insbesondere Flaschen (4) umfassen.

16. Vorrichtung nach Anspruch 15, **dadurch gekennzeichnet, dass** die Einrichtung (19) zum Evakuieren eine Einrichtung zum Evakuieren des Hohlraums der hohlkörperförmigen Werkstücke umfasst.

17. Vorrichtung nach Anspruch 15 oder 16, **gekennzeichnet durch** eine Einrichtung zum Einlassen von Prozessgas in den Hohlraum der hohlkörperförmigen Werkstücke.

18. Verfahren zum CVD-Peschichten von Werkstücken mit einer Vorrichtung für CVD-Beschichtungen, insbesondere nach einem der Ansprüche 1 bis 17,
**gekennzeichnet durch** die Schritte:
- Einführen von zumindest zwei Werkstücken in eine Beschichtungsstation (3, 31 - 46),
- Evakuieren,
- Befördern der zumindest einen. Beschichtungsstation (31 - 46) mit einer Transporteinrichtung (2),
- Verbinden einer stationären Einrichtung (25) zur Erzeugung elektromagnetischer Wellen mit der zumindest einen Beschichtungsstation (31 - 46),
- Erzeugen eines Plasmas in zumindest einem Teilbereich der Beschichtungsstation (31 - 46),
- Belüften, und
- Ausführen der werkstücke.

19. Verfahren nach Anspruch 18, **dadurch gekennzeichnet, daß** der Schritt des Erzeugens eines Plasmas in zumindest einem Teilbereich der Beschichtungsstation (31 - 46) den Schritt des Erzeugens eines gepulsten Plasmas.

20. Verfahren nach einem der vorstehenden Ansprüche, **dadurch gekennzeichnet, daß** der Schritt des Erzeugens eines Plasmas in zumindest einem Teilbereich den Schritt des gemeinsamen CVD-Beschichtens zumindest zweier Werkstücke umfaßt.

21. Verfahren nach einem der Ansprüche 18 bis 20, wobei der Schritt des Einführens von zumindest zwei Werkstücken in die zumindest eine Beschichtungsstation (31 - 46) den .Schritt des Einführens eines Halters (51 - 65) umfaßt, auf welcher die Werkstücke angeordnet sind.

22. Verfahren nach einem der Ansprüche 18 bis 21, wobei der Schritt des Beförderns der Beschichtungsstation (31 - 46) mit einer Transporteinrichtung (2) die Schritte des Beförderns von einer Zuführposition (9) zu einer Evakuierungsposition (11), einer Beschichtungsposition (13) und einer Entladeposition (15) umfaßt.

23. Verfahren nach einem der Ansprüche 18 bis 22, **dadurch gekennzeichnet, daß** der Schritt des Beförderns der Beschichtungsstation (31 - 46) mit einer Transporteinrichtung (2) den Schritt des Verlangsamens der Transportgeschwindigkeit während des Beschichtens, insbesondere den Schritt des Anhaltens während des Beschichtens umfaßt.

24. Verfahren nach einem der Ansprüche 18 bis 23, **dadurch gekennzeichnet, daß** der Schritt des Erzeugens eines Plasmas in zumindest einem Teilbereich der Beschichtungsstation (31 - 46) den Schritt des Erzeugens elektromagnetischer Wellen, insbesondere des Erzeugens von Mikrowellen umfaßt.

25. Verfahren nach einem der Ansprüche 18 bis 24, **dadurch gekennzeichnet, daß** der Schritt des Evakuierens den Schritt des sequentiellen Evakuierens mit zumindest zwei Pumpstufen (191, 192, 193) umfaßt.

26. Verfahren nach einem der Ansprüche 18 bis 25, **dadurch gekennzeichnet, dass** der Schritt des Evakuierens den Schritt des Evakuierens des Hohlraums hohlkörperförmiger Werkstücke, insbesondere von Flaschen umfasst.

27. Verfahren nach einem der Ansprüche 18 bis 26, **dadurch gekennzeichnet, dass** der Schritt des Erzeugens eines Plasmas den Schritt des Einlassens eines Prozessgases umfasst.

28. Verfahren nach Anspruch 27, wobei der Schritt des Einlassens eines Prozessgases den Schritt des Einlassens eines Prozessgases in den Hohlraum hohlkörperförmiger Werkstücke umfaßt.

## Claims

1. Apparatus (1) for CVD coatings, comprising a transport device (2), at least one coating station (3, 31 - 46) for coating workpieces, at least one device (19) for evacuating the coating station (3, 31 - 46) and a device for generating a plasma in at least one sub-region of the coating station (3, 31 - 46),
wherein at least coating station (31 - 46) is conveyed with the transport device (2),
wherein at least one coating station (31 - 46) is conveyed with the transport device (2), at least two workpieces can be received in the at least one coating station (3, 31 - 46), and wherein the device for generating a plasma in at least one sub-region of the coating station (3, 31 - 46) comprises a stationary device for generating electromagnetic waves (25), **characterised by** a device for connecting the device (25) for generating electromagnetic waves to the at least one coating station (3, 31 - 46).

2. Apparatus according to claim 1, **characterised in that** the transport device (2) conveys the coating stations (31 - 46) one after the other from at least one supply position (9) to at least one evacuation position (11), at least one coating position (13) and at least one unloading position (15).

3. Apparatus according to claim 2, **characterised by** at least four coating stations (31 - 34) which are arranged on the transport device (2) in such a way that one of the coating stations (31 - 34) is in the at least one supply position (9), the at least one evacuation position (11) and the at least one unloading position (15) respectively if one of the coating stations (31 - 34) is in the at least one coating position (13).

4. Apparatus according to one of the claims 1 to 4, **characterised in that** the device for generating a plasma in at least one sub-region of the coating station (31 - 46) comprises a device for generating a pulsed plasma.

5. Apparatus according to one of the claims 1 to 4, **characterised in that** the workpieces are arranged on at least one holder (51 - 65) which can be received in the at least one coating station (3, 31 - 46).

6. Apparatus according to one of the claims 1 to 5, **characterised in that** the workpieces are arranged in the coating station on at least two planes.

7. Apparatus according to one of the claims 1 to 6, **characterised in that** the transport device (2) slows downs the transport speed, in particular stops, during coating.

8. Apparatus according to one of the claims 1 to 7, **characterised in that** the transport device (2) comprises a rotating apparatus.

9. Apparatus according to one of the claims 1 to 8, **characterised in that** the transport device (2) comprises a longitudinally running apparatus.

10. Apparatus according to any preceding claim, wherein the device for generating electromagnetic waves comprises a device (25) for generating microwaves.

11. Apparatus according to one of the claims 1 to 10, **characterised in that** the evacuation device (19) comprises at least two pump stages (191, 192, 193).

12. Apparatus according to one of the preceding claims, **characterised by** a device for sequential connection of the at least one coating station (3, 31 - 46) to the at least two pump stages (191, 192, 193).

13. Apparatus according to one of the claims 1 to 12, **characterised by** a device for the admission of process gases.

14. Apparatus according to one of the claims 1 to 13, **characterised by** fixing devices for the at least two workpieces.

15. Apparatus according to claim 14, wherein the fixing devices comprise receiving members (7) for workpieces in the form of hollow bodies, particularly bottles (4).

16. Apparatus according to claim 15, **characterised in that** the evacuation device comprises a device for evacuating the hollow space of the workpieces in the form of hollow bodies.

17. Apparatus according to claim 15 or 16, **characterised by** a device for the admission of process gas into the hollow space of the workpieces in the form of hollow bodies.

18. Method for CVD coating of workpieces with an apparatus for CVD coatings, in particular according to one of the claims 1 to 17, **characterised by** the steps:
- introduction of at least two workpieces into a coating station (3, 31 - 46),
- evacuation,
- conveying of the at least one coating station (31 - 46) with a transport device (2),
- connection of a stationary device (25) for generating electromagnetic waves to the at least one coating station (31 - 46),
- generation of a plasma in at least one sub-region of the coating station (31 - 46),
- ventilation, and
- removal of the workpieces.

19. Method according to claim 18, **characterised in that** the step of generating a plasma in at least one sub-region of the coating station (31 - 46) comprises the step of generating a pulsed plasma.

20. Method according to one of the preceding claims, **characterised in that** the step of generating a plasma in at least one sub-region comprises the step of joint CVD coating of at least two workpieces.

21. Method according to one of the claims 18 to 20, wherein the step of introducing at least two workpieces into the at least one coating station (31 - 46) comprises the step of introducing a holder (51 - 65) on which the workpieces are arranged.

22. Method according to one of the claims 18 to 21, wherein the step of conveying the coating station (31 - 46) with a transport device (2) comprises the steps of conveying from a supply position (9) to an evacuation position (11), a coating position (13) and an unloading position (15).

23. Method according to one of the claims 18 to 22, **characterised in that** the step of conveying the coating station (31 - 46) with a transport device (2) comprises the step of slowing down the transport speed, in particular the step of stopping, during coating.

24. Method according to one of the claims 18 to 23, **characterised in that** the step of generating a plasma in at least one sub-region of the coating station (31 - 46) comprises the step of generating electromagnetic waves, in particular generating microwaves.

25. Method according to one of the claims 18 to 24, **characterised in that** the evacuation step comprises the sequential evacuation step with at least two pump stages (191, 192, 193).

26. Method according to one of the claims 18 to 25, **characterised in that** the evacuation step comprises the step of evacuation of the hollow space of workpieces formed as hollow bodies, particularly bottles.

27. Method according to one of the claims 18 to 26, **characterised in that** the step of generating a plasma comprises the step of admission of a process gas.

28. Method according to claim 27, wherein the step of admission of a process gas comprises the step of admission of a process gas into the hollow space of workpieces in the form of hollow bodies.

## Revendications

1. Dispositif (1) destiné à des revêtements par dépôt chimique en phase vapeur, comportant un dispositif de transport (2), au moins un poste de revêtement (3, 31 à 46) pour le revêtement de pièces, au moins un dispositif (19) pour la mise sous vide du poste de revêtement (3, 31 à 46), et un dispositif pour la génération d'un plasma dans au moins une zone partielle du poste de revêtement (3, 31 à 46),
l'au moins un poste de revêtement (31 à 46) étant transporté avec le dispositif de transport (2),
au moins deux pièces pouvant être introduites dans l'au moins un poste de revêtement (3, 31 à 46), et
le dispositif pour la génération d'un plasma dans au moins une zone partielle du poste de revêtement (3, 31 à 46) comportant un dispositif agencé de façon stationnaire pour la génération d'ondes électromagnétiques (25),
**caractérisé par** un dispositif (23) pour relier le dispositif (25) de génération d'ondes électromagnétiques à l'au moins un poste de revêtement (3, 31 à 46).

2. Dispositif selon la revendication 1, **caractérisé en ce que** le dispositif de transport (2) transporte le poste de revêtement (31 à 46) successivement depuis au moins une position d'amenée (9) vers au moins une position de mise sous vide (11), au moins une position de revêtement (13) et au moins une position de déchargement (15).

3. Dispositif selon la revendication 2, **caractérisé par** au moins quatre postes de revêtement (31 à 34), qui sont disposés sur le dispositif de transport (2) de telle sorte qu'un des postes de revêtement (31 à 34) se trouve respectivement dans la, au moins une, position d'amenée (9), la, au moins une, position de mise sous vide (11) et la, au moins une, position de déchargement (15), lorsque l'un des postes de revêtement (31 à 34) se trouve dans la, au moins une, position de revêtement (13).

4. Dispositif selon l'une des revendications 1 à 4, **caractérisé en ce que** le dispositif pour la génération d'un plasma dans au moins une zone partielle du poste de revêtement (31 à 46), comporte un dispositif pour la génération d'un plasma pulsé.

5. Dispositif selon l'une des revendications 1 à 4, **caractérisé en ce que** les pièces sont disposées sur au moins un support (51 à 65), qui peut être introduit dans l'au moins un, poste de revêtement (3, 31 à 46).

6. Dispositif selon l'une des revendications 1 à 5, **caractérisé en ce que** les pièces sont disposées sur au moins deux plans dans le poste de revêtement.

7. Dispositif selon l'une des revendications 1 à 6, **caractérisé en ce que** le dispositif de transport (2) ralentit la vitesse de transport, notamment s'arrête, pendant le revêtement.

8. Dispositif selon l'une des revendications 1 à 7, **caractérisé en ce que** le dispositif de transport (2) comporte un transporteur rotatif.

9. Dispositif selon l'une des revendications 1 à 8, **caractérisé en ce que** le dispositif de transport (2) comporte un transporteur longitudinal.

10. Dispositif selon l'une des revendications précédentes, dans lequel le dispositif pour la génération d'ondes électromagnétiques comporte un dispositif (25) pour la génération de micro-ondes.

11. Dispositif selon l'une des revendications 1 à 10, **caractérisé en ce que** le dispositif (19) de mise sous vide comporte au moins deux étages de pompage (191, 192, 193).

12. Dispositif selon l'une des revendications précédentes, **caractérisé par** un dispositif pour la liaison séquentielle de l'au moins un poste de revêtement (3, 31 à 46) avec les, au moins deux, étages de pompage (191, 192, 193).

13. Dispositif selon l'une des revendications 1 à 12, **caractérisé par** un dispositif pour l'admission de gaz de traitement.

14. Dispositif selon l'une des revendications 1 à 13, **caractérisé par** des moyens de fixation pour les, au moins deux, pièces.

15. Dispositif selon la revendication 14, dans lequel les moyens de fixation comportent des réceptions (7) pour des pièces en forme de corps creux, notamment des bouteilles (4).

16. Dispositif selon la revendication 15, **caractérisé en ce que** le dispositif (19) de mise sous vide comporte un dispositif pour la mise sous vide de l'espace creux des pièces en forme de corps creux.

17. Dispositif selon la revendication 15 ou 16, **caractérisé par** un dispositif d'admission de gaz de procédé dans l'espace creux des pièces en forme de corps creux.

18. Procédé de revêtement par dépôt chimique en phase vapeur de pièces, avec un dispositif destiné à des revêtements par dépôt chimique en phase vapeur, notamment selon l'une des revendications 1 à 17,
**caractérisé par** les étapes :
- d'introduction d'au moins deux pièces dans un poste de revêtement (3, 31 à 46),
- de mise sous vide,
- de transport de l'au moins un poste de revêtement (31 à 46) avec un dispositif de transport (2),
- liaison d'un dispositif stationnaire (25) pour la génération d'ondes électromagnétiques avec l'au moins un poste de revêtement (31 à 46),
- génération d'un plasma dans au moins une zone partielle du poste de revêtement (31 à 46),
- aération, et
- évacuation des pièces.

19. Procédé selon la revendication 18, **caractérisé en ce que** l'étape de la génération d'un plasma dans au moins une zone partielle du poste de revêtement (31 à 46) *[comprend]* l'étape de la génération d'un plasma pulsé.

20. Procédé selon l'une des revendications précédentes, **caractérisé en ce que** l'étape de la génération d'un plasma dans au moins une zone partielle comprend l'étape du revêtement commun par dépôt chimique en phase vapeur d'au moins deux pièces.

21. Procédé selon l'une des revendications 18 à 20, dans lequel l'étape de l'introduction d'au moins deux pièces dans l'au moins un poste de revêtement (31 à 46) comprend l'étape de l'introduction d'un support (51 à 65) sur lequel sont disposées les pièces.

22. Procédé selon l'une des revendications 18 à 21, dans lequel l'étape du transport des postes de revêtement (31 à 46) avec un dispositif de transport (2) comprend les étapes du transport depuis une position d'amenée (9) vers une position de mise sous vide (11), une position de revêtement (13) et une position de déchargement (15).

23. Procédé selon l'une des revendications 18 à 22, **caractérisé en ce que** l'étape du transport des postes de revêtement (31 à 46) avec un dispositif de transport (2) comprend l'étape du ralentissement de la vitesse de transport pendant le revêtement, notamment l'étape de l'arrêt pendant le revêtement.

24. Procédé selon l'une des revendications 18 à 23, **caractérisé en ce que** l'étape de la génération d'un plasma dans au moins une zone partielle du poste de revêtement (31 à 46) comprend l'étape de la génération d'ondes électromagnétiques, notamment de la génération de micro-ondes.

25. Procédé selon l'une des revendications 18 à 24, **caractérisé en ce que** l'étape de la mise sous vide comprend l'étape de la mise sous vide séquentielle avec au moins deux étages de pompage (191, 192, 193).

26. Procédé selon l'une des revendications 18 à 25, **caractérisé en ce que** l'étape de la mise sous vide comprend l'étape de la mise sous vide de l'espace creux de pièces en forme de corps creux, notamment de bouteilles.

27. Procédé selon l'une des revendications 18 à 26, **caractérisé en ce que** l'étape de la génération d'un plasma comprend l'étape de l'admission d'un gaz de procédé.

28. Procédé selon la revendication 27, dans lequel l'étape de l'admission d'un gaz de procédé comprend l'étape de l'admission d'un gaz de procédé dans l'espace creux de pièces en forme de corps creux.
